# DEMANDE DE BREVET EUROPEEN

(11) **EP 4 748 780 A1**
(43) Date de publication de la demande: **27.05.2026**
(21) Numéro de dépôt: 25217091.5
(22) Date de dépôt: 19.11.2025
(51) Int. Cl.: B82Y 20/00, H01S 5/183, H10F 77/12, G02F 1/00, G02F 1/21

(54) **STRUCTURE MULTICOUCHES POUR DISPOSITIF PHOTONIQUE ET PROCÉDÉ POUR SA FABRICATION**

(30) Priorité: 21.11.2024 FR 2412774
(71) Demandeur: Centre National de la Recherche Scientifique, 75016 Paris (FR); STMicroelectronics International N.V., 1228 Plan-les-Ouates, Geneva (CH); UNIVERSITE CLAUDE BERNARD LYON 1, 69100 Villeurbanne (FR); Ecole Centrale de Lyon, 69134 Ecully Cedex (FR); Institut National des Sciences Appliquées de Lyon, 69100 Villeurbanne (FR); Ecole Superieure de Chimie Physique Electronique de Lyon, 69100 Villeurbanne (FR)
(72) Inventeur: CUEFF, Sébastien, 69380 CHASSELAY (FR); BERGUIGA, Lotfi, 69007 LYON (FR); BENTATA, Fouad, 38000 GRENOBLE (FR)
(74) Mandataire: Santarelli

(57) **Abrégé**

L'invention concerne une structure multicouches pour dispositif photonique, comprenant, sur un substrat support (10), un empilement de couches (20) comprenant : une couche sous-jacente (21) en oxyde de magnésium, une couche active (22) en sulfure d'antimoine, disposée sur la couche sous-jacente (21) et en contact direct avec elle, une couche sus-jacente (23) en oxyde de magnésium, disposée sur la couche active (22) et en contact direct avec elle, et une couche de recouvrement (24) disposée au-dessus de la couche sus-jacente (23).

## Description

La présente invention s'inscrit dans le domaine de la fabrication des dispositifs photoniques, en particulier des dispositifs nanophotoniques.

Plus particulièrement, la présente invention concerne une structure multicouches pour dispositif photonique, ainsi qu'un procédé de fabrication d'une telle structure multicouches. L'invention concerne également l'utilisation d'une telle structure multicouches dans un dispositif photonique, et un dispositif photonique la comprenant.

Actuellement, un goulot d'étranglement important dans le domaine de la photonique, par exemple de l'optique intégrée, réside dans le fait que les dispositifs standards ne peuvent pas être accordés et reconfigurés : leurs propriétés sont fixées une fois que le dispositif est fabriqué. C'est particulièrement vrai lorsque les couches actives de ces dispositifs sont formées en silicium, nitrure de silicium, silice, ou encore dioxyde de titane, qui sont les matériaux actuellement les plus utilisés en nanophotonique. Les structures cristallographiques de ces matériaux ne permettent pas d'obtenir les propriétés de modulation et de reconfiguration qui sont indispensables pour des applications visées telles que l'affichage, la biodétection intégrée et le balayage de faisceaux pour les véhicules autonomes, etc. C'est pourquoi de nombreuses recherches portent à l'heure actuelle sur l'intégration, dans les dispositifs photoniques, de technologies permettant d'étendre les possibilités des systèmes passifs vers des fonctionnalités actives.

Il existe des possibilités de modulations extrinsèques qui sont d'ores et déjà disponibles dans les technologies CMOS (Semi-conducteur à oxyde métallique complémentaire), notamment : les effets thermo-optiques, les microsystèmes électromécaniques (MEMS) et les cristaux liquides, ou encore les effets non-linéaires. Ces quatre technologies, utilisées depuis plusieurs décennies, ont toutes joué un rôle majeur dans le développement de systèmes photoniques modulables. Bien qu'elles soient clairement différentes les unes des autres, elles présentent des points communs qui, à terme, compliquent leurs utilisations dans les futurs systèmes nanophotoniques reconfigurables. En premier lieu, ces techniques ne permettent qu'une modulation volatile des dispositifs. En d'autres termes, la modulation ne peut être conservée en l'absence du stimulus externe ayant déclenché cette modulation. Dans le cas d'un système photonique reconfigurable, il serait donc nécessaire lors de leur mise en œuvre, soit de reprogrammer l'ensemble du système avant utilisation, soit de le maintenir continuellement sous tension. Il résulterait de cette limitation, combinée au besoin de puissances élevées, une consommation énergétique importante. Ces plateformes risqueraient donc de ne pas être évolutives et soutenables pour les futurs systèmes incorporant plusieurs milliers de composants.

Partant de ce constat, il est désormais clair que les futurs circuits photoniques intégrés efficaces devront inclure d'autres matériaux, optiquement actifs, dans les plateformes photoniques basées sur le silicium. La cointégration de matériaux fonctionnels avec le silicium promet des dispositifs et des systèmes ultra-efficaces dotés de propriétés uniques, telles que des propriétés reconfigurables non volatiles pour le calcul neuromorphique ou la détection, ainsi que des sources de lumière et des modulateurs efficaces pour les techniques d'orientation de faisceau. Bien que cette cointégration semble être un moyen idéal de profiter du meilleur des deux mondes, le chemin à parcourir est pavé d'obstacles en termes de compatibilité de fabrication ou de fonctions. De grands défis demeurent à l'heure actuelle dans la conception et la fabrication de structures reconfigurables et accordables, nécessaires pour un certain nombre d'applications dans les communications optiques, le calcul optique, le stockage d'informations, l'imagerie, les détecteurs, les capteurs, etc.

Pour adresser ces défis, de nombreux groupes de recherche dans le monde ont lancé des recherches sur les matériaux à changement de phase et leur utilisation en photonique intégrée. Les matériaux à changement de phase présentent en effet un haut potentiel pour fournir une solution rapide, à basse énergie et non-volatile, pour permettre une modification post-fabrication de la réponse des dispositifs photoniques.

Contrairement à la plupart des matériaux, qui présentent des propriétés optiques indépendantes de leur état, les matériaux à changement de phase présentent des propriétés optiques différentes selon leur état : les changements de structure amorphe à cristalline dans ces matériaux résultent en une modulation significative de leurs réponses optiques. L'intérêt de ces matériaux pour le domaine de la photonique est ainsi indéniable : ils permettent de moduler l'environnement optique via la modification de leurs indices de réfraction.

Parmi ces matériaux, la communauté scientifique s'intéresse particulièrement aux matériaux présentant une transition isolant-métal, tels que le dioxyde de vanadium, et aux matériaux de type chalcogénures avec une transition amorphe-cristallin, tels que le tellurure de germanium d'antimoine GeSbTe, le tellurure de germanium GeTe, etc. Le document US 2023/288773 décrit un métasystème hybride reconfigurable pour système diélectrique à base d'un matériau à changement de phase, en particulier le tellurure de germanium d'antimoine.

En comparaison avec les techniques de modulation décrites ci-avant, les matériaux à changement de phase présentent l'avantage d'une très grande accordabilité, bien supérieure à celles obtenues par injection de porteurs, chauffage ou via des effets non-linéaires. De plus, certains autres atouts spécifiques s'y ajoutent, comme par exemple la non-volatilité des matériaux chalcogénures, c'est-à-dire la conservation de la modification d'indice de réfraction après l'arrêt du stimulus, et le caractère multi-stimuli des changements de phase : ces derniers peuvent être induits thermiquement, optiquement et/ou électriquement.

Les matériaux à changement de phase utilisés jusqu'à présent ont démontré un fort potentiel pour la modulation multi-physique à l'échelle nanométrique. Cependant, ils présentent une limitation qui est liée à leur forte absorption optique dans la gamme visible/infra-rouge.

Récemment, de nouveaux matériaux à changement de phase ont vu le jour, notamment des matériaux à base d'antimoine, tel que le sulfure d'antimoine Sb₂S₃, qui présente à la fois une forte modulation d'indice non-volatile et des pertes optiques négligeables dans ses deux états amorphe/cristallin. Le sulfure d'antimoine se caractérise en outre par un contraste important dans ses propriétés optiques entre son état amorphe et son état cristallin dans le spectre visible. Les caractérisations et premières démonstrations de dispositifs à base de Sb₂S₃ ont laissé entrevoir des propriétés extrêmement prometteuses pour la nanophotonique. A titre d'exemple, le document de Yiman et al., 2024, Arxiv.org, Cornell University Library, décrit une hétérostructure multicouches pour dispositif optique, comprenant une couche de sulfure d'antimoine en tant que matériau à changement de phase.

Cependant, les premiers essais de nanostructuration des hétérostructures comprenant une couche en sulfure d'antimoine se sont révélés infructueux.

Schématiquement, les étapes typiques pour la fabrication d'un dispositif photonique à matériau à changement de phase incluent, après une phase initiale de conception, des étapes de :
- dépôt de couches successives sur un substrat, dont une couche de ce matériau, pour former un empilement de couches. Un tel dépôt est généralement réalisé par des techniques comme le dépôt par pulvérisation cathodique ou l'évaporation sous vide ;
- lithographie pour définir des motifs spécifiques sur la surface de la couche de matériau à changement de phase, et gravure pour sculpter ce matériau selon le motif souhaité, de sorte à conférer à cette couche la fonction optique spécifique visée ;
- ainsi que, le cas échéant, intégration dans un dispositif photonique plus global. Un traitement thermique peut en outre être appliqué, préalablement ou postérieurement à l'intégration, pour induire ou stabiliser la phase désirée du matériau à changement de phase.

Dans le contexte de l'utilisation des matériaux à changement de phase à base d'antimoine, en particulier le sulfure d'antimoine, pour la fabrication de dispositifs photoniques, plusieurs limitations ont été constatées, principalement dues à :
- la faible adhérence de ces matériaux à la plupart des substrats, couches et superstrats utilisés en photonique. Cette faible adhérence engendre des problèmes d'instabilité mécanique à différents stades de fabrication des structures multicouches complexes pour dispositifs photoniques, notamment lors du dépôt d'autres couches de matériaux, lors de l'étape de lithographie et lors du traitement thermique visant à provoquer le changement de phase de ce matériau. A toutes ces étapes, le risque est fort qu'il se produise une délamination de la couche de matériau, qui serait hautement préjudiciable au bon fonctionnement du dispositif ;
- et la forte réactivité chimique de ces matériaux avec la plupart des développeurs utilisés pour la lithographie, tels que l'hydroxyde de tétraméthylammonium (TMAH).

Afin de contourner ce dernier problème, il a notamment été proposé par l'art antérieur d'utiliser, pour l'étape de lithographie, des résines basse résolution, ne nécessitant pas la mise en œuvre de développeurs tels que le TMAH, et en laissant la résine et/ou le masque dur métallique à la surface des nanostructures, comme illustré par exemple dans les publications de Lu et al., 2021, ACS Nano. 15(12): 19722-19732, et de Moitra et al., 2023, Advanced Materials 35: 2205367. Ces méthodes ne résolvent toutefois pas le problème posé de manière satisfaisante. Il en résulte des dispositifs très peu efficaces et très limités en termes d'applications potentielles.

Il subsiste ainsi toujours à l'heure actuelle un besoin pour un dispositif photonique efficace, stable, fiable et à propriétés optiques modulables à base d'un matériau à changement de phase à base d'antimoine, en particulier le sulfure d'antimoine. La présente invention vise à proposer un tel dispositif. Plus particulièrement, la présente invention vise à proposer une structure multicouches comprenant une couche active d'un matériau à changement de phase à base d'antimoine, notamment de sulfure d'antimoine, destinée à être intégrée dans un dispositif photonique, tel qu'un circuit optique intégré ou un dispositif à métasurface, cette structure multicouches présentant une bonne stabilité mécanique et chimique au contact des développeurs de la lithographie classiques dans ce domaine.

Des objectifs supplémentaires de l'invention sont que cette structure multicouches soit simple à fabriquer, qui plus est par les procédés de fabrication industriels conventionnels.

Selon un premier aspect, la présente invention concerne une structure multicouches pour dispositif photonique, tel qu'un circuit optique intégré, comprenant un empilement de couches sur un substrat support. Cet empilement de couches comprend :
- une couche, dite sous-jacente, en un premier matériau choisi parmi les oxydes de magnésium, d'hafnium, de zirconium, de zinc ou de strontium-titane, ou de l'un quelconque de leurs alliages, en particulier en un premier matériau qui est l'oxyde de magnésium,
- une couche, dite active, d'un sel d'antimoine et de soufre, sélénium ou tellure, en particulier en sulfure d'antimoine, cette couche active étant disposée sur la couche sous-jacente et en contact direct avec elle,

- une couche, dite sus-jacente, en un deuxième matériau choisi parmi les oxydes de magnésium, d'hafnium, de zirconium, de zinc ou de strontium-titane, ou de l'un quelconque de leurs alliages, en particulier en un deuxième matériau qui est l'oxyde de magnésium, cette couche sus-jacente étant disposée sur la couche active et en contact direct avec elle,
- et une couche de recouvrement en nitrure de silicium (Si₃N₄, également désigné SiN), dioxyde de silicium (SiO₂), trioxyde d'aluminium (Al₂O₃), dioxyde de titane (TiO₂) ou oxynitrure de silicium (SiOₓN_{y}, par exemple Si₂N₂O), cette couche de recouvrement étant disposée au-dessus de la couche sus-jacente.

Cette structure multicouches répond avantageusement à l'ensemble des objectifs que s'est fixée la présente invention.

En particulier, il a été constaté par les présents inventeurs que, de manière surprenante, la prise en sandwich de la couche active de sel d'antimoine, en particulier de sulfure d'antimoine, entre la couche sous-jacente et la couche sus-jacente formées en les matériaux spécifiques définis par la présente invention, permet d'assurer la stabilité mécanique de l'empilement de couches, tant lors de la formation de cet empilement sur le substrat support, que lors des étapes ultérieures de lithographie, gravure et traitement thermique, notamment à des températures aussi hautes que 350°C, bien supérieures à la température de cristallisation du sel d'antimoine (qui est d'environ 260°C pour le sulfure d'antimoine Sb₂S₃). Aucun délaminage n'est observé, au niveau du substrat support ou du superstrat (couche de recouvrement), à aucune de ces étapes. Il en résulte une efficacité et une fiabilité des dispositifs photoniques dans lesquels cette structure est intégrée, qui sont fortement améliorées par rapport aux solutions à base de matériaux à changement de phase proposés par l'art antérieur. Ces résultats avantageux ne sont pas obtenus lorsque la couche sous-jacente et/ou la couche sus-jacente sont formées en d'autres oxydes, par exemple en oxyde de titane, oxyde d'ytterbium ou oxyde d'indium-étain, pour lesquelles on observe un délaminage.

Les propriétés optiques de la structure multicouches selon l'invention sont également améliorées, et elles peuvent avantageusement être facilement modulées, par un stimulus thermique induisant la modification de l'état du sel d'antimoine, et par voie de conséquence de son indice de réfraction. Cet indice de réfraction est en outre avantageusement conservé après l'arrêt du stimulus, si bien que la modulation des propriétés optiques de la structure ne requiert qu'une faible consommation énergétique.

En outre, les matériaux sélectionnés par l'invention pour la constitution de la couche sous-jacente et de la couche sus-jacente possèdent des propriétés optiques ne perturbant pas le bon fonctionnement optique de la structure, telles que la transparence dans le visible et le proche infrarouge et un faible indice de réfraction. Cet indice de réfraction est d'environ 1,72 seulement pour l'oxyde de magnésium MgO dans le domaine de l'infrarouge. De plus, une faible épaisseur de ces couches, de l'ordre de quelques nanomètres, suffit pour assurer une adhésion totale de la couche active de sel d'antimoine au sein de l'empilement. La mise en œuvre de la couche sous-jacente et de la couche sus-jacente permet ainsi d'améliorer la stabilité de la structure, notamment au niveau de la couche active de sel d'antimoine, sans toutefois compromettre les propriétés optiques de la structure.

Ainsi, la structure multicouches selon l'invention constitue avantageusement une plateforme versatile, efficace et fiable convenant à un grand nombre d'applications du domaine de la photonique.

Le substrat support de la structure selon l'invention, qui constitue un support mécanique pour l'empilement de couches, est classique en lui-même dans le domaine des structures multicouches pour dispositif photonique. Il peut être formé en matériau présentant des propriétés électriques et/ou optiques adaptées à la fonctionnalité visée pour la structure, ou neutres. Le substrat support peut par exemple être formé en silicium, dioxyde de silicium (SiO₂), quartz, ou plus généralement tout type de verre, trioxyde d'aluminium (Al₂O₃), etc. Un substrat support transparent dans les longueurs d'ondes d'intérêt pour l'application visée, par exemple en dioxyde de silicium ou quartz, sera plus particulièrement mis en œuvre pour les applications en transmission, alors que des substrats supports opaques, par exemple en silicium, pourront être choisis pour d'autres applications.

La couche sous-jacente peut être disposée directement sur le substrat support. Dans des modes de réalisation alternatifs de l'invention, une ou plusieurs couches additionnelles sont intercalées entre le substrat support et la couche sous-jacente. Cette ou ces couches additionnelles peuvent être de tout type classique en lui-même dans le domaine des structures multicouches pour dispositif photonique, et présenter toute propriété adaptée à l'application visée. A titre d'exemple, une ou plusieurs couches métalliques, par exemple en or, platine, tungstène, titane, etc., peuvent être intercalées entre le substrat support et la couche sous-jacente. De tels modes de réalisation sont notamment adaptés à des applications en réflexion de la structure multicouches. Une couche métallique structurée selon un motif adapté à l'application visée, par exemple en platine, peut en outre par exemple être disposée en-dessous, en particulier immédiatement en-dessous, de la couche sous-jacente dans l'empilement de couches, pour former dans ce dernier des pistes intégrées permettant le chauffage par voie électrique de la couche active, et ainsi d'y provoquer le changement de phase du sel d'antimoine à la demande.

Le premier matériau, formant la couche sous-jacente, peut être un oxyde de magnésium, un oxyde d'hafnium, un oxyde de zirconium, un oxyde de zinc ou un oxyde de strontium-titane, ou encore un oxyde de l'un quelconque de leurs alliages. Le premier matériau peut par exemple être choisi parmi l'oxyde de magnésium MgO, le dioxyde d'hafnium HfO₂, le dioxyde de zirconium ZrO₂, l'oxyde de zinc ZnO et le titanate de strontium SrTiO₃.

Le deuxième matériau, formant la couche sus-jacente, peut également être un oxyde de magnésium, un oxyde d'hafnium, un oxyde de zirconium, un oxyde de zinc ou un oxyde de strontium-titane, ou encore un oxyde de l'un quelconque de leurs alliages. Le deuxième matériau peut par exemple être choisi parmi l'oxyde de magnésium MgO, le dioxyde d'hafnium HfO₂, le dioxyde de zirconium ZrO₂, l'oxyde de zinc ZnO et le titanate de strontium SrTiO₃.

Dans des modes de réalisation préférés de l'invention sur le plan de la facilité de mise en œuvre industrielle, le premier matériau, formant la couche sous-jacente, et le deuxième matériau, formant la couche sus-jacente, sont identiques. Il s'agit notamment de l'oxyde de magnésium. Un tel mode de réalisation n'est toutefois nullement limitatif de l'invention, cette dernière n'excluant pas que soient mis en œuvre au sein de la structure un premier matériau et un deuxième matériau différents l'un de l'autre.

La couche active de l'empilement de couches selon l'invention peut être formée en un sel d'antimoine et de soufre, un sel d'antimoine et de sélénium ou un sel d'antimoine et de tellure. Ce sel ne comprend de préférence pas de germanium. La couche active de l'empilement de couches peut notamment être formée en un sel répondant à l'une des formules suivantes :
- Sbₓ₁S_{y1},
- Sbₓ₂Se_{y2},
- Sbₓ₃Te_{y3},
dans lesquelles chacun de x1, x2, x3, y1, y2 et y3 est un nombre compris entre 1 et 8.

Préférentiellement, la couche active est formée en un sel d'antimoine de nombre d'oxydation III. La couche active peut ainsi par exemple être formée en sulfure d'antimoine Sb₂S₃, en séléniure d'antimoine Sb₂Se₃ ou en tellurure d'antimoine Sb₂Te₃.

Dans des modes de réalisation particuliers de l'invention, la couche sous-jacente est formée en oxyde de magnésium, la couche active est formée en sulfure d'antimoine, et la couche sus-jacente est formée en oxyde de magnésium. Ainsi, une structure multicouches particulièrement préférée dans le cadre de l'invention comprend, dans l'empilement de couches :
- une couche sous-jacente en oxyde de magnésium (MgO) ;
- une couche active en sulfure d'antimoine (Sb₂S₃) ;
- et une couche sus-jacente en oxyde de magnésium (MgO).

Cette structure multicouches peut répondre à l'une ou plusieurs des caractéristiques décrites ci-avant ou ci-après.

La couche de recouvrement est classique en elle-même pour les structures multicouches pour dispositifs photoniques. Elle y remplit une fonction de protection chimique et mécanique : elle empêche le sel d'antimoine de la couche active de réagir avec l'environnement, et le confine dans un volume donné. Le matériau formant cette couche est choisi de sorte qu'elle soit transparente optiquement dans les longueurs d'ondes d'intérêt pour l'application visée.

La couche de recouvrement est de préférence disposée sur la couche sus-jacente, et en contact direct avec elle. Il est alternativement possible d'intercaler une ou plusieurs couches additionnelles entre la couche sus-jacente et la couche de recouvrement, de telles couches additionnelles étant classiques en elles-mêmes dans le domaine des structures multicouches pour dispositifs photoniques, et pouvant en particulier jouer le rôle de couche(s) de passivation. De telles couches additionnelles doivent être transparentes optiquement dans les longueurs d'ondes d'intérêt pour l'application visée.

L'empilement de couches de la structure selon l'invention peut en outre comprendre une ou plusieurs autres couches, également classiques en elles-mêmes dans le domaine, au-dessus de la couche de recouvrement, de telles couches devant là encore être transparentes optiquement dans les longueurs d'ondes d'intérêt pour l'application visée.

Au titre de couches additionnelles pouvant être disposées entre le substrat support et la couche sous-jacente, entre la couche sus-jacente et la couche de recouvrement, et/ou au-dessus de cette dernière, on peut par exemple citer celles formées dans les matériaux suivants : or, dioxyde de titane, silicium, germanium, aluminium, trioxyde d'aluminium, silicium-germanium, etc., avec la contrainte que les couches disposées au-dessus de la couche active dans l'empilement de couches soient transparentes optiquement dans les longueurs d'ondes d'intérêt pour l'application visée.

Préférentiellement, la couche active de sel d'antimoine est nanostructurée, cette nanostructuration pouvant être réalisée en surface, de préférence au niveau de sa face supérieure, qui est définie comme la face disposée sous la couche sus-jacente, en regard de cette dernière, ou dans toute son épaisseur. On entend dans la présente, par nanostructurée, que des motifs, dits motifs de nanostructuration, de taille nanométrique, typiquement entre 1 nm et 10 µm, sont formés dans la couche active, au niveau de sa face supérieure ou dans toute son épaisseur. Plus particulièrement, dans le cadre de la présente invention, les motifs de nanostructuration peuvent par exemple présenter une largeur et une longueur (c'est-à-dire les dimensions mesurées dans le plan de la surface supérieure de la couche active) qui sont chacune comprises entre 1 nm et 1000 µm, par exemple entre 1 nm et 10 µm, et une profondeur, mesurée perpendiculairement à ce plan, comprise entre 1 nm et 1 µm en fonction de l'épaisseur de la couche active. Cette nanostructuration peut être réalisée selon tout motif souhaité, par exemple pour former des séries de plots cylindriques et/ou parallélépipédiques. Il entre dans les compétences de l'homme du métier de déterminer le motif de nanostructuration à appliquer sur la couche active de sel d'antimoine, en fonction des propriétés optiques souhaitées pour la structure multicouches selon l'application visée.

L'épaisseur de chacune des couches de l'empilement de couches selon l'invention peut être de tout ordre. Pour des applications dans le domaine de la nanophotonique, ces épaisseurs sont de préférence inférieures ou égales à quelques micromètres, par exemple comprises entre 10 nm et 1 µm, ou même entre 10 nm et 500 nm.

Dans des modes de réalisation particuliers de l'invention, la couche active de sel d'antimoine présente une épaisseur comprise entre 10 nm et 1 µm, de préférence comprise entre 10 nm et 250 nm.

Chacune de la couche sous-jacente et de la couche sus-jacente présente de préférence une épaisseur comprise entre 0,5 et 100 nm, préférentiellement comprise entre 0,8 et 10 nm, en particulier comprise entre 1 et 5 nm. Comme indiqué ci-avant, des épaisseurs aussi faibles que 1 à 5 nm permettent d'assurer la stabilité mécanique de l'empilement y compris sous les contraintes mécaniques exercées sur lui lors de sa fabrication, son intégration et son utilisation. Les épaisseurs de la couche sous-jacente et de la couche sus-jacente peuvent être égales l'une à l'autre, ou différentes.

La couche de recouvrement présente quant à elle une épaisseur supérieure ou égale à 5 nm, de préférence comprise entre 5 nm et 2 µm.

Dans des modes de réalisation particuliers de l'invention, le sel d'antimoine, en particulier le sulfure d'antimoine, de la couche active est à l'état amorphe, c'est-à-dire qu'il est dépourvu de fractions cristallines.

Dans des modes de réalisation particuliers alternatifs de l'invention, le sel d'antimoine, en particulier le sulfure d'antimoine, de la couche active présente des fractions cristallines. Il peut alors présenter tout degré de cristallinité, c'est-à-dire tout rapport de fractions cristallines et fractions amorphes. Le sel d'antimoine, en particulier le sulfure d'antimoine, de la couche active peut en particulier présenter un degré de cristallinité de 100 %.

Le substrat support peut présenter toute forme et toutes dimensions souhaitées, et fonction de l'application exacte envisagée, les formes planes étant les plus courantes.

De manière plus générale, le choix exact des formes et matériaux des différents éléments constitutifs de la structure multicouche selon l'invention est fonction de la fonctionnalité visée pour cette structure multicouches, et des spécificités du dispositif photonique dans lequel elle est destinée à être intégrée, et il entre dans les compétences de l'homme du métier de procéder à un tel choix, sur la base de ses connaissances générales et dans le respect des caractéristiques édictées par la présente invention.

Un autre aspect de l'invention concerne un procédé de fabrication d'une structure multicouches selon l'invention. Ce procédé comprend la formation, sur un substrat support, d'un empilement de couches par dépôt successif :
- d'une couche, dite sous-jacente, en un premier matériau choisi parmi les oxydes de magnésium, d'hafnium, de zirconium, de zinc ou de strontium-titane, ou de l'un quelconque de leurs alliages, en particulier en un premier matériau qui est l'oxyde de magnésium,
- d'une couche, dite active, formée d'un sel d'antimoine et de soufre, sélénium ou tellure, cette couche active étant disposée sur la couche sous-jacente et en contact direct avec elle, en particulier de sulfure d'antimoine,
- d'une couche, dite sus-jacente, en un deuxième matériau choisi parmi les oxydes de magnésium, d'hafnium, de zirconium, de zinc ou de strontium-titane, ou de l'un quelconque de leurs alliages, sur la couche active et en contact direct avec elle, en particulier en un deuxième matériau qui est l'oxyde de magnésium,
- et d'une couche de recouvrement en nitrure de silicium, dioxyde de silicium, trioxyde d'aluminium, dioxyde de titane ou oxynitrure de silicium, au-dessus de la couche sus-jacente.

La formation de l'empilement de couches peut comprendre le dépôt de toute couche additionnelle ou pluralité de couches additionnelles, que ce soit sous la couche sous-jacente, sur la couche sus-jacente, entre cette dernière et la couche de recouvrement, et/ou sur la couche de recouvrement, cette ou ces couche(s) additionnelle(s) éventuelle(s) étant telle(s) que défini ci-avant.

Le dépôt des différentes couches de l'empilement de couches peut être effectué de toute manière classique en elle-même, les différentes couches pouvant être déposées par la même technique, ou par des techniques différentes.

Au titre de telles techniques pouvant être mises en œuvre pour la formation des couches de l'empilement de couches, on peut notamment citer le dépôt par pulvérisation cathodique, l'évaporation sous vide par faisceau d'électrons (EBPVD), le dépôt par assistance ionique (IAD), le dépôt chimique en phase vapeur assisté par plasma (PECVD), l'épitaxie par jets moléculaire, le dépôt par ablation laser, l'évaporation thermique, etc. L'ensemble de ces techniques étant bien connues de l'homme du métier, il entre dans ses compétences de savoir en déterminer les conditions opératoires exactes à mettre en œuvre, en fonction notamment du matériau à déposer et de l'épaisseur de couche visée.

Le procédé selon l'invention peut répondre à l'une ou plusieurs des caractéristiques décrites ci-avant en référence à la structure multicouches selon l'invention, pour tout ce qui concerne les couches de l'empilement, par exemple leurs constitutions et leurs épaisseurs, et la nanostructuration de la couche active.

Dans des modes de mise en œuvre particuliers de l'invention, le procédé comprend en outre une étape de nanostructuration de la couche active, de préférence au niveau de sa face supérieure, et optionnellement sur toute son épaisseur. Cette étape de nanostructuration peut être réalisée selon tout motif souhaité, et à tout stade de la fabrication de la structure multicouches. A titre d'exemples, cette étape peut être réalisée avant, ou de préférence après, le dépôt de la couche sus-jacente, après le dépôt d'une autre couche au-dessus de cette dernière, après le dépôt de la couche de recouvrement, ou après le dépôt de toute autre couche disposée au-dessus d'elle dans l'empilement ou la structure, ou même après l'intégration de la structure multicouches dans un dispositif photonique plus complexe.

Là encore, cette étape de nanostructuration peut être réalisée par toute technique conventionnelle permettant de structurer précisément le matériau à changement de phase d'un dispositif photonique, dans le cas présent le sel d'antimoine, selon le motif de nanostructuration nécessaire pour obtenir la fonction optique spécifique souhaitée.

Dans des modes de mise en œuvre particuliers de l'invention, l'étape de nanostructuration de la couche active est réalisée par lithographie et gravure, selon un protocole opératoire classique en lui-même. Pour ce qui concerne les métasurfaces dans les régimes visibles à proche infrarouge, dans lesquelles les motifs de nanostructuration doivent présenter des dimensions critiques d'environ 100 nm, l'utilisation de techniques de lithographie haute résolution telles que la lithographie ultraviolet profonde dans les installations industrielles ou la lithographie par faisceau d'électrons (EBL) dans les laboratoires, sera privilégiée.

Le protocole mis en œuvre pour l'étape de nanostructuration de la couche active peut notamment comprendre les étapes suivantes, toutes classiques en elles-mêmes dans le domaine.

La première étape de ce protocole consiste en l'application, sur la couche souhaitée de l'empilement, d'au moins une, et optionnellement plusieurs, couche(s) de résine photosensible, telle qu'une résine d'hydrogénosilsesquioxane (HSQ), de méthacrylate de méthyle (MMA), de poly(méthacrylate de méthyle) (PMMA), de styrène-méthyl méthacrylate, de naphthoquinone diazide, phénolique polymérisée, novolaque, etc., chacune de ces couches pouvant présenter une épaisseur comprise entre 20 et 500 nm, par exemple entre 100 et 300 nm. Cette application peut par exemple être réalisée par dépôt par centrifugation (en anglais, « spin-coating ») et suivie par un recuit à une température et pendant une durée dépendantes de la résine considérée. En particulier, la résine HSQ est convertie en SiO₂ sous l'exposition ultérieure au faisceau d'électrons, ce qui en fait un excellent choix pour un masque dur. L'un des principaux avantages de l'utilisation de la résine HSQ est sa capacité à atteindre une nanostructuration haute résolution en dessous de 10 nm. Cela en fait un choix idéal pour créer des motifs et des structures précises dans la couche active de l'empilement de couches selon l'invention. Selon les configurations de la structure multicouches, et notamment la nature du substrat support, par exemple lorsque ce dernier est formé en quartz, une couche d'une résine électriquement conductrice, telle que la résine Electra 92 de la société Allresist, peut être déposée au-dessus de la ou des couche(s) de résine(s) photosensible(s), afin d'assurer la décharge des électrons lors de l'étape ultérieure du protocole. Un tel dépôt peut être réalisé par la même technique que celle décrite ci-avant pour les résines photosensibles, par dépôt par centrifugation puis recuit.

La deuxième étape de ce protocole de nanostructuration consiste en l'exposition de la ou des résine(s) à la lumière d'une source lumineuse, telle qu'un rayonnement ultraviolet (photolithographie) ou à un faisceau électronique (lithographie électronique), à travers un masque lithographique reproduisant le motif de nanostructuration souhaité. Cette exposition modifie les propriétés de solubilité de la ou des résine(s) au niveau des zones exposées.

La troisième étape de ce protocole de nanostructuration consiste en le développement, par trempage ou rinçage avec un solvant, dit développeur, tel que le TMAH, qui enlève, selon le type de résine mis en œuvre, les parties de la résine qui ont été exposées à la lumière ou au faisceau électronique (pour les résines dites positives) ou les parties de résine qui n'y ont pas été exposées (pour les résines dites négatives), laissant le motif désiré sur la surface de la couche de l'empilement.

La quatrième étape du protocole de nanostructuration est la gravure, qui est réalisée au niveau de la partie de surface non couverte par la résine, le motif résiduel de résine photosensible agissant comme un masque protégeant les autres parties de la surface. La gravure peut être réalisée par toute technique conventionnelle dans le domaine, par exemple par une solution chimique apte à détruire le matériau non protégé, telle qu'une solution de fluorure d'hydrogène ou une solution apte à dissoudre les matériaux des couches de l'empilement visées (gravure chimique), ou par un plasma réactif apte à éroder le(s) matériau(x) non protégé(s) par la résine, tel qu'un plasma d'air, de chlore, d'oxygène, d'hexafluorure de soufre, de dihydrogène, de trifluorométhane, de bromure d'hydrogène, etc., ou d'une combinaison de ces espèces (gravure sèche). Lorsque la couche active à graver est recouverte d'une ou plusieurs couches, par exemple la couche sus-jacente et la couche de recouvrement, l'étape de gravure peut être réalisée en plusieurs sous-étapes, chacune adaptée au matériau particulier de chacune de ces couches.

L'étape finale du protocole de nanostructuration consiste en le retrait de la ou des résine(s) photosensible(s) restante(s), généralement à l'aide d'un solvant approprié, tel que le fluorure d'hydrogène ou l'acétone par exemple, ou encore par plasma, par exemple d'oxygène, en fonction de la résine particulière utilisée. Comme indiqué ci-avant, il a notamment été constaté par les présents inventeurs que, de manière surprenante, bien que les sels d'antimoine visés par la présente invention, tel que le sulfure d'antimoine, soient sensibles aux développeurs classiques tels que le TMAH, la présence de la couche sus-jacente protège la couche active de l'empilement de couches selon l'invention de tout dommage causé par ces développeurs. En outre, la prise en sandwich de la couche active de tels matériaux à changement de phase entre la couche sous-jacente et la couche sus-jacente conformément à l'invention permet de nanostructurer cette couche active par les méthodes conventionnelles, sans qu'il se produise aucun délaminage de l'empilement de couches dans lequel elle s'insère. Il en résulte une plus grande simplicité de mise en œuvre du procédé, par rapport aux solutions proposées par l'art antérieur.

Dans des modes de mise en œuvre particuliers de l'invention, le procédé comprend en outre une étape de cristallisation du sel d'antimoine, en particulier du sulfure d'antimoine, de la couche active, pour lui conférer tout degré de cristallinité souhaité. Cette étape de cristallisation peut être réalisée par toute méthode conventionnelle, par exemple par traitement thermique, à une température supérieure ou égale à 260°C, de préférence supérieure ou égale à 280°C, ou par laser. Dans des modes de mise en œuvre particulièrement avantageux de l'invention, l'étape de cristallisation est réalisée par voie électrique, assurant un chauffage de la couche active par effet Joule, notamment au moyen de pistes métalliques, par exemple en platine, intégrées dans l'empilement de couches sous la couche sous-jacente, comme décrit ci-avant. Cette étape de cristallisation peut être réalisée à tout stade d'avancement du procédé selon l'invention après le dépôt de la couche sus-jacente, par exemple après le dépôt de l'ensemble des couches de l'empilement, après l'étape de nanostructuration de la couche active, après l'intégration de la structure multicouches dans un dispositif photonique plus complexe, etc.

La structure multicouches selon l'invention est destinée à être utilisée au sein d'un dispositif photonique.

Ainsi, un autre aspect de l'invention concerne l'utilisation d'une structure multicouches selon l'invention dans un dispositif photonique. L'intégration de la structure multicouches dans un tel dispositif peut être réalisée de toute manière classique en elle-même.

L'invention concerne également un dispositif photonique, en particulier un dispositif nanophotonique, comprenant une structure multicouches selon l'invention. A titre d'exemples de tels dispositifs, on peut citer les filtres optiques reconfigurables, au sein desquels la couche active de l'empilement de couches selon l'invention sert à reconfigurer spectralement le filtre, et les autres couches peuvent servir à optimiser la précision et la résolution du filtre.

La structure multicouches selon l'invention, et le dispositif photonique qui l'intègre, peuvent trouver application dans de nombreux domaines, par exemple dans le domaine des communications optiques, du calcul optique, du stockage d'informations, de l'imagerie, des détecteurs, des capteurs, etc. Ils peuvent trouver intérêt dans les domaines des mesures biologiques et chimiques, de la reconnaissance de scène, ou encore de l'instrumentation pour le spatial.

La modulation des propriétés optiques de la structure multicouches selon l'invention, et du dispositif photonique qui l'intègre, peut être réalisée facilement, et de manière non volatile, en opération du dispositif, par cristallisation/amorphisation du sel d'antimoine, en particulier du sulfure d'antimoine, de la couche active de l'empilement de couches. Tant cette cristallisation que cette amorphisation peuvent par exemple être réalisées par traitement laser ou par voie électrique, comme décrit ci-dessus.

Les caractéristiques et avantages de l'invention apparaîtront plus clairement à la lumière des exemples de mise en œuvre ci-après, fournis à simple titre illustratif et nullement limitatifs de l'invention, avec l'appui des figures 1 à 10, dans lesquelles :
La figure 1 représente de manière schématique une structure multicouches selon l'invention, en vue en coupe selon un plan transversal.
La figure 2 montre des photographies, pour un empilement multicouches Au / SiO₂ / Sb₂S₃ sur un substrat en silicium, en a/ de la face d'un ruban adhésif ayant été appliquée sur une zone de la face supérieure de cet empilement, puis retirée, et en b/ de la face supérieure de cet empilement, la zone sur laquelle le ruban adhésif a été appliqué occupant la partie de gauche sur la photographie, indiquée par une flèche.
La figure 3 montre des images de microscopie optique de la face supérieure d'un empilement multicouches MgO / Sb₂S₃/ Si₃N₄ sur un substrat en silicium, en a/ avant et en b/ après, l'application, puis le retrait, d'un ruban adhésif sur une zone de cette face supérieure, cette zone étant indiquée par une flèche.
La figure 4 montre des images de microscopie optique des faces supérieures d'empilements multicouches, après l'application, puis le retrait, d'un ruban adhésif sur une zone de cette face supérieure, en a/ pour un empilement MgO / Sb₂S₃ / Si₃N₄ sur un substrat en silicium, et en b/ pour un empilement MgO / Sb₂S₃ / MgO / Si₃N₄ sur un substrat en dioxyde de silicium.
La figure 5 montre des images de microscopie optique de la face supérieure d'un empilement multicouches MgO / Sb₂S₃ / Si₃N₄ sur un substrat en dioxyde de silicium, en a/ avant, et en b/ après, immersion dans un bain de TMAH.
La figure 6 montre des images de microscopie optique de la face supérieure d'un empilement multicouches MgO / Sb₂S₃ / MgO / Si₃N₄ sur un substrat en dioxyde de silicium, en a/ avant, et en b/ après, immersion dans un bain de TMAH.
La figure 7 montre des images de microscopie optique des faces supérieures d'empilements multicouches soumis à un traitement thermique, en a/ pour un empilement SiO₂ / Sb₂S₃ / SiO₂ à la température de 180°C, et en b/ pour un empilement SiO₂ / MgO / Sb₂S₃ / MgO / SiO₂ à la température de 350°C.
La figure 8 montre des photographies de la face supérieure d'un empilement multicouches TiO₂ / Sb₂S₃ sur un substrat en silicium, en a/ avant et en b/ après, l'application, puis le retrait, d'un ruban adhésif sur une zone de cette face supérieure, cette zone étant indiquée par une flèche.
La figure 9 montre des photographies de la face supérieure d'un empilement multicouches InSnO / Sb₂S₃ sur un substrat en silicium, en a/ avant et en b/ après, l'application, puis le retrait, d'un ruban adhésif sur une zone de cette face supérieure, cette zone étant indiquée par une flèche.
La figure 10 montre des photographies de la face supérieure d'un empilement multicouches Y₂O₃ / Sb₂S₃ sur un substrat en silicium, en a/ avant et en b/ après, l'application, puis le retrait, d'un ruban adhésif sur une zone de cette face supérieure, cette zone étant indiquée par une flèche.

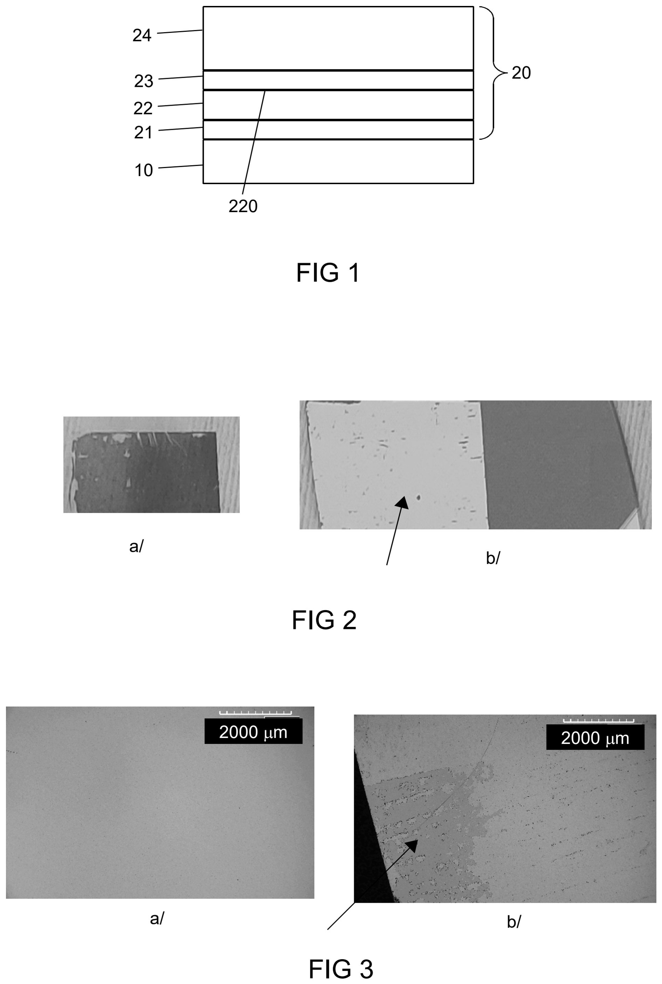

Un exemple de structure multicouches selon l'invention est représenté de manière schématique sur la figure 1. Sur cette figure, les rapports des épaisseurs respectives des différentes couches ne sont pas représentatifs de la réalité, certaines des couches ayant été artificiellement épaissies pour une meilleure visibilité de la figure.

Cette structure comprend un substrat support 10, qui peut par exemple être formé en silicium, dioxyde de silicium, quartz, trioxyde d'aluminium, et présenter toute forme et toute épaisseur, et sur lequel est déposé un empilement de couches 20.

L'empilement de couches 20 est formé d'une pluralité de couches, comprenant au moins, énoncées dans l'ordre de la plus proche à la plus éloignée du substrat support 10 :
- une couche sous-jacente 21, par exemple d'épaisseur comprise entre 1 et 5 nm, en un premier matériau choisi parmi les oxydes de magnésium, d'hafnium, de zirconium, de zinc ou de strontium-titane, ou de l'un quelconque de leurs alliages, par exemple en oxyde de magnésium ;
- une couche active 22 en sel d'antimoine et de soufre, sélénium ou tellure, par exemple en sulfure d'antimoine, par exemple d'épaisseur comprise entre 10 et 500 nm, disposée sur la couche sous-jacente 21 et en contact direct avec cette dernière ;
- une couche sus-jacente 23, par exemple d'épaisseur comprise entre 1 et 5 nm, en un deuxième matériau choisi parmi les oxydes de magnésium, d'hafnium, de zirconium, de zinc ou de strontium-titane, ou de l'un quelconque de leurs alliages, par exemple en oxyde de magnésium, cette couche sus-jacente 23 étant disposée sur la couche active 22, et en contact direct avec cette dernière ;
- et une couche de recouvrement 24, par exemple d'épaisseur comprise entre 5 et 2000 nm, en nitrure de silicium, dioxyde de silicium, trioxyde d'aluminium, dioxyde de titane ou oxynitrure de silicium.

Dans l'exemple particulier représenté sur la figure 1, l'empilement de couches 20 ne comprend aucune couche additionnelle. L'invention n'exclut nullement la présence d'une ou plusieurs telles couches additionnelles, classiques en elles-mêmes dans le domaine, pouvant être disposées entre le substrat support 10 et la couche sous-jacente 21, entre la couche sus-jacente 23 et la couche de recouvrement 24, et/ou au-dessus de cette dernière.

La couche active 22 est de préférence nanostructurée en surface, au niveau de sa face dite supérieure 220 disposée en regard de la couche sus-jacente 23 (nanostructuration non visible sur la figure 1).

1 / Exemple 1 - Protocole général de préparation des structures multicouches Des structures multicouches conformes à l'invention, et des structures multicouches non conformes à l'invention, sont préparées sur des substrats support 10 en silicium, dioxyde de silicium ou quartz, sous forme de plaques planes carrées de 2 cm de côté dans cet exemple.

Le protocole général de dépôt des couches des empilements de couches sur les substrats est le suivant :
- les couches de sulfure d'antimoine Sb₂S₃ et d'oxyde de magnésium MgO sont déposées, successivement, par la technique d'évaporation par faisceau électronique dans une chambre de dépôt adaptée (bâti de la société Kurt J. Lesker), dans laquelle les matériaux cibles Sb₂S₃ et MgO (achetés auprès du fournisseur Advanced Engineering Materials Limited pour le Sb₂S₃ et auprès du fournisseur Codex International pour le MgO) sont évaporés sous pression réduite de 5.10⁻⁶ mbar et à température ambiante, à l'aide d'un faisceau électronique, afin d'obtenir les épaisseurs de couches souhaitées (comprises entre 10 et 500 nm pour le Sb₂S₃ et entre 1 et 5 nm pour le MgO). L'épaisseur de chaque couche en formation est mesurée en temps réel par une microbalance à cristal de quartz ;
- les couches de SiO₂ et Y₂O₃ sont également déposées par évaporation par faisceau électronique, selon le même protocole ;
- les couches de nitrure de silicium Si₃N₄ sont déposées dans un environnement de salle blanche, par la technique de dépôt chimique en phase vapeur assisté par plasma (PECVD), au moyen d'un dispositif de la marque Oxford Instruments, en utilisant les gaz précurseurs SiH₄ et NH₃, à une pression de 2,67 mbar et à la température de 180°C pour éviter la cristallisation du Sb₂S₃ lors du dépôt, ou par pulvérisation cathodique, par pulvérisation d'une cible de silicium, sous plasma mélangeant argon et azote, afin d'obtenir l'épaisseur de couche souhaitée (15 nm) ;
- les couches de TiO₂ et InSnO sont déposées par pulvérisation cathodique.
Dans tous les exemples ci-après, les images de microscopie optique sont obtenues au moyen d'un microscope optique Hirox RH-200 3D digital.

### 2/ Exemple 2 - Test d'adhérence au substrat

Deux empilements multicouches sont testés dans cet exemple :
- un empilement E1 comportant, successivement, les couches suivantes sur un substrat support en silicium : 200 nm Au / 100 nm SiO₂ / 140 nm Sb₂S₃ ;
- un empilement E2 comportant, successivement, les couches suivantes sur un substrat support en silicium : 5 nm MgO / 140 nm Sb₂S₃/ 15 nm Si₃N₄.

Le test d'adhérence est réalisé en utilisant un ruban adhésif (référence Double Sided Tape de la marque Scotch^{®}), qui est appliqué sur une zone de la face supérieure de chaque empilement, puis retiré.

Les résultats obtenus sont montrés sur la figure 2 pour l'empilement E1 et sur la figure 3 pour l'empilement E2.

Concernant l'empilement E1, on observe clairement que l'intégralité de la couche de Sb₂S₃ a été retirée de l'empilement par le ruban adhésif. Cette couche est présente sur la face du ruban adhésif (en a/ sur la figure 2), et absente de la zone de la surface de l'empilement sur laquelle le ruban adhésif a été appliqué (en b/ sur la figure 2, zone de gauche plus claire de la photographie).

Concernant l'empilement E2, on observe, en b/ sur la figure 3, que seule la couche de recouvrement en Si₃N₄ a été retirée de la zone de la surface de l'empilement sur laquelle le ruban adhésif a été appliqué (cette zone étant indiquée par une flèche sur la figure).

Ces résultats montrent clairement que l'ajout de la couche sous-jacente de MgO améliore significativement l'adhérence de la couche de Sb₂S₃ au substrat support, puisqu'aucun décollement de cette couche n'est provoqué par le retrait du ruban adhésif lorsqu'elle est disposée sur cette couche de MgO sous-jacente.

### 3/ Exemple 3 - Test d'adhérence au superstrat

Deux empilements multicouches sont testés dans cet exemple :
- un empilement E3 comportant, successivement, les couches suivantes sur un substrat support en silicium : 4 nm MgO / 150 nm Sb₂S₃ / 15 nm Si₃N₄ ;
- un empilement E4 comportant, successivement, les couches suivantes sur un substrat support en dioxyde de silicium : 4 nm MgO / 150 nm Sb₂S₃/ 1 nm MgO / 15 nm Si₃N₄.

Le test d'adhérence est réalisé en utilisant le même ruban adhésif que dans l'Exemple 2, qui est appliqué sur une zone de la face supérieure de chaque empilement, puis retiré.

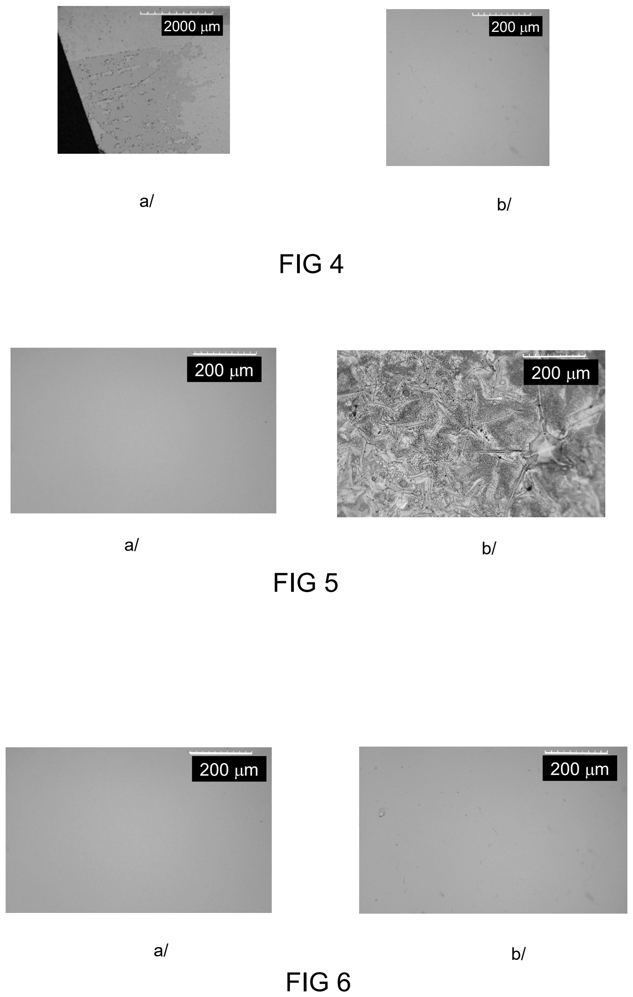

Les résultats obtenus sont montrés sur la figure 4, en a/ pour l'empilement E3 et en b/ pour l'empilement E4. Comme on peut le voir, concernant l'empilement E3, la surface de l'empilement est endommagée : la couche de Si₃N₄ a été décollée par le ruban adhésif. La couche de Sb₂S₃ est quant à elle restée en place, sur la couche de MgO sous-jacente. Concernant l'empilement E4, conforme à l'invention, l'ensemble des couches sont restées en place sur le substrat, y compris la couche supérieure (« superstrat ») de Si₃N₄ : la surface de l'empilement est propre, et apparait non affectée par le retrait de l'adhésif.

La même expérience a été menée avec un empilement similaire à l'empilement E4, mais dans lequel des couches épaisses de 2 µm de SiO₂ ont été insérées de part et d'autre du sandwich MgO / Sb₂S₃ / MgO / Si₃N₄. Un résultat similaire est obtenu : on n'observe aucun délaminage de l'empilement (aucun décollement d'aucune couche) lors du test d'adhérence au ruban adhésif.

Ces résultats démontrent que l'ajout de la couche sus-jacente de MgO améliore significativement l'adhérence des couches disposées au-dessus de la couche de Sb₂S₃, c'est-à-dire les couches protectrices de Si₃N₄ et de SiO₂.

### 4/ Exemple 4 - Test de résistance chimique

Deux empilements multicouches sont testés dans cet exemple, les empilements E3 et E4 décrits dans l'Exemple 3, sur des substrats supports en dioxyde de silicium.

Le test utilise le solvant TMAH (hydroxyde de tétraméthylammonium), qui est couramment utilisé pour le développement de résines comme la HSQ, la MMA ou la PMMA (résines à haute résolution) exposées par lithographie, dans le cadre d'un procédé de nanostructuration de l'empilement de couches, par transfert par gravure de la nanostructure de la résine à l'empilement de couches. Chacun des échantillons testés est immergé dans du TMAH concentré à 25% en volume. Le temps d'immersion est de 15 s (temps de développement standard des procédés de nanostructuration classiques). Ensuite, les échantillons sont trempés dans de l'eau distillée pendant 60 s pour arrêter la réaction chimique.

Les figures 5 et 6 montrent les images obtenues par microscopie optique avant et après la mise en œuvre du test, respectivement pour l'empilement E3 et pour l'empilement E4.

Comme on peut l'observer sur la figure 5 pour l'empilement non conforme à l'invention E3, le dépôt direct de la couche de Si₃N₄ sur la couche de Sb₂S₃ n'est pas suffisant pour protéger le matériau Sb₂S₃ contre une réaction chimique dans un bain de TMAH. Après le traitement chimique, comme visible en b/ sur la figure, des fractures de la couche de protection Si₃N₄ et des attaques sur l'empilement sont observées.

A l'inverse, comme on l'observe clairement sur la figure 6, pour l'empilement conforme à l'invention E4, aucune réaction chimique avec le TMAH ne s'est produite. La présence de couches de MgO de part et d'autre de la couche de Sb₂S₃ a bien un effet protecteur sur l'empilement.

### 5/ Exemple 5 - Test de cristallisation

Le test de cristallisation vise à valider la stabilité mécanique du matériau actif Sb₂S₃ lors du changement de sa phase amorphe vers sa phase cristalline nécessaire à la modification de ses propriétés optiques. Ce changement de phase nécessite un traitement à haute température, par exemple à 285°C.

Deux empilements multicouches sont testés dans cet exemple :
- un empilement E5 comportant, successivement, sur un substrat support en silicium, les couches suivantes : 2 µm SiO₂ / 70 nm Sb₂S₃ (amorphe) / 2 µm SiO₂ ;
- un empilement E6 comportant, successivement, sur un substrat support en silicium, les couches suivantes : 2 µm SiO₂/ 5 nm MgO / 70 nm Sb₂S₃ (amorphe) / 5 nm MgO / 2 µm SiO₂.

Les échantillons sont soumis dans une chaufferette (« Heat Cell » de la société Linkam) à un traitement thermique par augmentation de la température à une vitesse de 30°C/min jusqu'à atteindre 350°C. Le chauffage est effectué sous observation microscopique au moyen d'un microscope optique, pour détecter des changements tels que des fissures mécaniques et/ou la cristallisation.

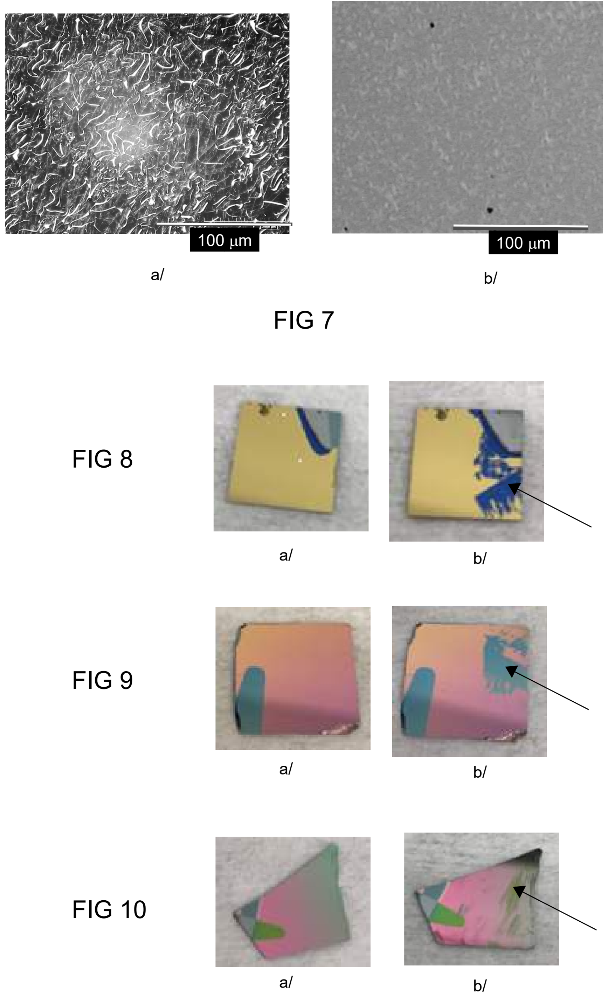

Les résultats obtenus à l'issue du traitement thermique sont montrés sur la figure 7.

On observe que l'empilement E5 non conforme à l'invention, en a/ sur la figure, est détruit, des fissures y apparaissent dès la température de 180°C. A l'inverse, l'empilement E6 conforme à l'invention n'a pas subi d'endommagement même lorsqu'il a atteint la température de 350°C, largement au-dessus de la température de cristallisation du Sb₂S₃. A cette température, le Sb₂S₃ a en outre bien cristallisé, comme en témoigne l'apparition de grains, qui changent de couleurs lorsque l'on fait varier la polarisation de la lumière dans le microscope. Ceci a en outre été confirmé en mesurant les propriétés de l'échantillon en ellipsométrie.

Ces résultats montrent que le sandwich MgO/Sb₂S₃/MgO offre une meilleure intégration et une bonne stabilité mécanique et chimique, contrairement à la couche de Sb₂S₃ seule, notamment pendant les étapes de fabrication, et cristallisation.

### 6/ Exemple 6 - Nanostructuration

Dans cette expérience, la nanostructuration a été réalisée en utilisant la technique de lithographie par faisceau d'électrons (EBL).

### 6.1/ Préparation de l'empilement de couches

Un empilement de couches a été préparé sur un substrat en quartz, de la façon suivante :
- le substrat a été nettoyé en utilisant de l'acétone et de l'isopropanol ;
- le dépôt des couches a commencé par une fine couche de MgO (4 nm) comme couche sous-jacente, suivie de la couche active de Sb₂S₃ (140 nm), puis d'une fine couche de MgO (1 nm) comme couche sus-jacente. Ces couches ont été caractérisées en utilisant la profilométrie et la réflectométrie ;
- puis une couche de recouvrement de 15 nm d'épaisseur en Si₃N₄ a été déposée par PECVD à 180°C.

### 6.2/ Dépôt de résines

Une couche d'environ 100 nm de poly(méthacrylate de méthyle) (PMMA) a été déposée par dépôt par centrifugation sur la surface supérieure de l'empilement, à 4000 tr/min pendant 30 s, puis un recuit a été effectué à 180°C pendant 90 s. Une couche d'environ 100 nm de résine négative d'hydrogénosilsesquioxane (HSQ) a ensuite été déposée par dépôt par centrifugation sur la couche de PMMA, à 4000 tr/min pendant 30 s, puis un recuit a été effectué à 80°C pendant 4 min.

La résine conductrice Electra 92 (Allresist) a ensuite été déposée par dépôt par centrifugation à 4000 tr/min sur la surface supérieure de l'empilement, et cuite pendant 2 min à 85°C.

### 6.3/ Lithographie par faisceau d'électrons

La lithographie par faisceau d'électrons a été réalisée, pour former les motifs de nanostructuration souhaités, avec un système Raith avec les paramètres suivants : grossissement de 1100 fois, tension de 30 kV, ouverture de 7 µm, et courant de faisceau de 10 pA à 30 pA, à une dose nominale de 3,5.

### 6.4/ Développement chimique

L'échantillon a été développé par :
- immersion pendant 15 s dans l'eau distillée pour enlever la résine conductrice ;
- puis immersion dans un bain de développeur TMAH 25% pendant 15 s pour enlever les parties non exposées des résines HSQ et PMMA.

L'échantillon a été rincé dans l'eau déionisée pendant 60 s avec un flux doux d'eau déionisée pour arrêter le développement.

### 6.5/ Transfert des motifs de nanostructuration

Le transfert des motifs de nanostructuration a été réalisé par gravure ionique réactive (ICP-RIE), selon les étapes successives suivantes :
- transfert des nanostructures vers la couche de recouvrement (Si₃N₄) : 20 s, recette de gravure : mélange de gaz (Ar (100 sccm), CHF₃ (30 sccm), N₂ (10 sccm)), puissance ICP 300 W, puissance RF : 35 W ;
- gravure de la couche sus-jacente de MgO : 2 s, recette de gravure : mélange de gaz (Cl₂ (10 sccm), Ar (5 sccm)), puissance ICP 250 W, puissance RF : 35 W ;
- gravure de la couche active de Sb₂S₃ : 15 s, recette de gravure : mélange de gaz (Ar (100 sccm), CHF₃ (30 sccm), N₂ (10 sccm)), puissance ICP 300 W, puissance RF : 35 W.

### 6.6/ Retrait du masque résiduel

Le retrait du masque résiduel HSQ a été réalisé dans un bain d'acétone pendant 1 min sous ultrasons, afin de dissoudre la couche de PMMA. La couche active de Sb₂S₃ est restée intacte pendant cette étape, ainsi que bien ancrée au substrat support grâce à la présence de la couche sous-jacente de MgO.

A l'issue de ce protocole, on observe que les motifs de nanostructuration ont été transférés à la couche active avec succès, avec la même résolution que sur le masque de résine HSQ, ceci sans délaminage des différentes couches de l'empilement et sans endommagement de la couche active de Sb₂S₃.

### Exemple 7 - Tests comparatifs d'adhérence au substrat

Trois empilements multicouches non conformes à l'invention sont testés dans cet exemple :
- un empilement E8 comportant, successivement, les couches suivantes sur un substrat support en silicium : 50 nm TiO₂ / 50 nm Sb₂S₃ ;
- un empilement E9 comportant, successivement, les couches suivantes sur un substrat support en silicium : 50 nm InSnO / 50 nm Sb₂S₃ ;
- un empilement E10 comportant, successivement, les couches suivantes sur un substrat support en silicium : 50 nm Y₂O₃/ 50 nm Sb₂S₃.

Le test d'adhérence est réalisé en utilisant un ruban adhésif (référence Double Sided Tape de la marque Scotch^{®}), qui est appliqué sur une zone de la face supérieure de chaque empilement, puis retiré.

Les résultats obtenus sont montrés sur la figure 8 pour l'empilement E8, sur la figure 9 pour l'empilement E9 et sur la figure 10 pour l'empilement E10.

Dans les trois cas, on observe clairement qu'une partie de la couche de Sb₂S₃ a été retirée de l'empilement par le ruban adhésif. Cette couche est en effet absente de la zone de la surface de l'empilement sur laquelle le ruban adhésif a été appliqué (en b/ sur chaque figure, zone indiquée par une flèche sur la photographie). Ces résultats montrent clairement que la couche de Sb₂S₃ adhère faiblement à la couche de TiO₂, très faiblement à la couche de InSnO et moyennement à la couche de Y₂O₃.

Ainsi, seule la couche sous-jacente de MgO conforme à l'invention présente une bonne adhérence à la couche de Sb₂S₃.

## Revendications

1. Structure multicouches pour dispositif photonique, comprenant un empilement de couches (20) sur un substrat support (10), **caractérisé en ce que** ledit empilement de couches (20) comprend :
- une couche dite sous-jacente (21) en un premier matériau qui est l'oxyde de magnésium,
- une couche dite active (22) en sulfure d'antimoine, ladite couche active étant disposée sur ladite couche sous-jacente (21) et en contact direct avec elle,
- une couche dite sus-jacente (23) en un deuxième matériau qui est l'oxyde de magnésium, ladite couche sus-jacente (23) étant disposée sur ladite couche active (22) et en contact direct avec elle,
- et une couche de recouvrement (24) en nitrure de silicium, dioxyde de silicium, trioxyde d'aluminium, dioxyde de titane ou oxynitrure de silicium, ladite couche de recouvrement (24) étant disposée au-dessus de ladite couche sus-jacente (23).

2. Structure selon la revendication 1, dans laquelle ladite couche active (22) est nanostructurée.

3. Structure selon la revendication 1 ou 2, dans laquelle ladite couche active (22) présente une épaisseur comprise entre 10 nm et 1 µm.

4. Structure selon l'une quelconque des revendications 1 à 3, dans laquelle ladite couche sous-jacente (21) présente une épaisseur comprise entre 0,5 et 100 nm.

5. Structure selon l'une quelconque des revendications 1 à 4, dans laquelle ladite couche sus-jacente (23) présente une épaisseur comprise 0,5 et 100 nm.

6. Structure selon l'une quelconque des revendications 1 à 5, dans laquelle ladite couche de recouvrement (24) présente une épaisseur supérieure ou égale à 5 nm.

7. Structure selon l'une quelconque des revendications 1 à 6, dans laquelle le sulfure d'antimoine de ladite couche active (22) est à l'état amorphe.

8. Structure selon l'une quelconque des revendications 1 à 6, dans laquelle le sulfure d'antimoine de ladite couche active (22) présente des fractions cristallines.

9. Procédé de fabrication d'une structure multicouches selon l'une quelconque des revendications 1 à 8, **caractérisé en ce qu'**il comprend la formation, sur un substrat support (10), d'un empilement de couches (20) par dépôt successif :
- d'une couche dite sous-jacente (21) en un premier matériau qui est l'oxyde de magnésium,
- d'une couche dite active (22) formée de sulfure d'antimoine, ladite couche active étant disposée sur ladite couche sous-jacente (21) et en contact direct avec elle,
- d'une couche dite sus-jacente (23) en un deuxième matériau qui est l'oxyde de magnésium, sur ladite couche active (22) et en contact direct avec elle,
- et d'une couche de recouvrement (24) en nitrure de silicium, dioxyde de silicium, trioxyde d'aluminium, dioxyde de titane ou oxynitrure de silicium, au-dessus de ladite couche sus-jacente (23).

10. Procédé selon la revendication 9, comprenant une étape de nanostructuration de ladite couche active (22).

11. Procédé selon la revendication 9 ou 10, comprenant une étape de cristallisation du sulfure d'antimoine de ladite couche active (22).

12. Utilisation d'une structure multicouches selon l'une quelconque des revendications 1 à 8 dans un dispositif photonique.

13. Dispositif photonique comprenant une structure multicouches selon l'une quelconque des revendications 1 à 8.
